(19) Europäisches Patentamt
European Patent Office
Office européen des brevets

(11) **EP 3 410 161 B1**

(12) **FASCICULE DE BREVET EUROPEEN**

(45) Date de publication et mention
de la délivrance du brevet:
**07.07.2021 Bulletin 2021/27**

(51) Int Cl.:
***G01V 99/00*** *(2009.01)*

(21) Numéro de dépôt: **18305610.0**

(22) Date de dépôt: **17.05.2018**

(54) **PROCÉDÉ D'EXPLOITATION D'UN BASSIN SÉDIMENTAIRE COMPORTANT DES HYDROCARBURES, AU MOYEN D'UNE MODÉLISATION STRATIGRAPHIQUE**

VERFAHREN ZUR ERFORSCHUNG VON KOHLENWASSERSTOFFEN AUS DEM SEDIMENTBECKEN, MITTELS STRATIGRAPHISCHER MODELLBILDUNG

METHOD OF EXPLORATION OF A HYDROCARBON SEDIMENTARY BASIN BY MEANS OF STRATIGRAPHIC MODELING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.06.2017 FR 1754935**

(43) Date de publication de la demande:
**05.12.2018 Bulletin 2018/49**

(73) Titulaire: **IFP Energies nouvelles**
**92852 Rueil-Malmaison Cedex (FR)**

(72) Inventeurs:
 • **HAMON, Youri**
 **78400 Chatou (FR)**
 • **BARBIER, Mickael**
 **30100 Ales (FR)**
 • **GRANJEON, Didier**
 **78110 Le Vesinet (FR)**
 • **CHAUVEAU, Benoit**
 **78420 Carrieres Sur Seine (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:

 • **ALBERTO CONSONNI ET AL: "Application of numerical modelling to a case of compaction-driven dolomitization: a Jurassic palaeohigh in the Po Plain, Italy", SEDIMENTOLOGY, vol. 57, no. 1, 1 janvier 2010 (2010-01-01), pages 209-231, XP055448783, ISSN: 0037-0746, DOI: 10.1111/j.1365-3091.2009.01103.x**
 • **YITIAN XIAO ET AL: "Reactive transport modeling of carbonate and siliciclastic diagenesis and reservoir quality prediction", 2006 ABU DHABI INTERNATIONAL PETROLEUM EXHIBITION AND CONFERENCE, 5 novembre 2006 (2006-11-05), XP055449495,**
 • **PAUL MEAKIN ET AL: "Modeling and simulation of pore-scale multiphase fluid flow and reactive transport in fractured and porous media", REVIEWS OF GEOPHYSICS, vol. 47, no. 3, 14 juillet 2009 (2009-07-14), XP055449619, ISSN: 8755-1209, DOI: 10.1029/2008RG000263**
 • **YITIAN XIAO ET AL: "Fundamental Approaches to Dolomitization and Carbonate Diagenesis in Different Hydrogeological Systems and the Impact on Reservoir Quality Distribution", SEDIMENTOLOGY, 26 mars 2013 (2013-03-26), XP055448602, ISSN: 0037-0746**

**(Cont. page suivante)**

- **GARETH D. JONES ET AL: "Geothermal convection in the Tengiz carbonate platform, Kazakhstan: Reactive transport models of diagenesis and reservoir quality", AAPG (AMERICAN ASSOCIATION OF PETROLEUM GEOLOGISTS)BULLETIN, vol. 90, no. 8, 1 août 2006 (2006-08-01), pages 1251-1272, XP055449502, US ISSN: 0149-1423, DOI: 10.1306/04030605194**

## Description

La présente invention concerne le domaine de l'exploration et de l'exploitation des gisements pétroliers ou de sites de stockage géologique de gaz.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire. La démarche générale de l'évaluation du potentiel pétrolier d'un bassin sédimentaire comporte des allers-retours entre une prédiction du potentiel pétrolier du bassin sédimentaire, réalisée à partir d'informations mesurées relatives au bassin étudié (analyse d'affleurements, campagnes sismiques, forages par exemple), et des forages d'exploration dans les différentes zones présentant le meilleur potentiel, afin de confirmer ou infirmer le potentiel prédit préalablement, et d'acquérir de nouvelles informations permettant de préciser les prédictions de potentiel pétrolier du bassin étudié.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation pour ces zones (par exemple à l'aide d'une simulation de réservoir, afin de définir les nombre et positions des puits d'exploitation permettant une récupération d'hydrocarbures optimale), à forer des puits d'exploitation et, de façon générale, à mettre en place les infrastructures de production nécessaires au développement du gisement.

L'évaluation du potentiel pétrolier d'un bassin sédimentaire peut se faire soit de manière probabiliste soit de manière analytique. L'approche analytique est le plus souvent mise en oeuvre au moyen de logiciels exécutés sur ordinateur, permettant la synthèse des données disponibles et la simulation de l'histoire géologique du bassin étudié. En fonction de la complexité de l'histoire géologique du bassin étudié, la famille des logiciels mis en œuvre pour l'approche analytique peut comprendre la simulation à une, deux ou trois dimensions, des processus sédimentaires, tectoniques, thermiques, hydrodynamiques, de chimie organique et inorganique qui interviennent lors de la formation d'un bassin pétrolier. On parle alors d'une démarche dite de « modélisation de bassin ».

Concernant plus particulièrement la modélisation des processus sédimentaires, on met en œuvre des logiciels dits de « simulation stratigraphique ». Ces logiciels visent notamment à évaluer différentes hypothèses sur les processus sédimentaires ayant contribué à l'architecture stratigraphique d'un bassin observé à l'actuel. De manière classique, la simulation de l'histoire du remplissage d'un bassin sédimentaire prend au moins en compte les paramètres suivants : (1) l'espace disponible pour la sédimentation, créé par des mouvements tectoniques et/ou eustatiques, (2) l'apport en sédiments dans le bassin, soit par les frontières, soit par l'intermédiaire d'une production ou d'une précipitation *in situ,* (3) le transport de ces sédiments dans l'espace disponible créé. Le logiciel DionisosFlow® développé par IFP Energies nouvelles (France) est un exemple d'un logiciel mettant en œuvre une simulation stratigraphique.

La prise en compte de la diagénèse dans les logiciels de simulation stratigraphique est à ce jour restreinte. En effet, le plus souvent, seul l'impact de la compaction mécanique sur l'épaisseur des couches sédimentaires, au fur et à mesure de l'enfouissement de ces couches dans le bassin, est pris en compte. Ainsi, dans le document (Granjeon & Joseph, 1999), on décrit des lois de compaction qui relient la porosité du sédiment à l'enfouissement, permettant ainsi de quantifier le volume des couches sédimentaires. Si une telle restriction peut être satisfaisante (c'est-à-dire produisant un résultat de simulation suffisamment proche de la réalité) pour des roches sédimentaires de type clastique, elle ne peut conduire à une simulation satisfaisante de la diagénèse précoce des roches carbonatées.

De manière générale, on appelle diagénèse la succession de modifications physico-chimiques et biologiques subies par des sédiments s'étant déposés au sein d'un bassin, et qui contribuent à des changements de texture et de composition de ces sédiments, après leur dépôt. En effet, les sédiments qui se déposent dans un bassin sédimentaire sont meubles et riches en eau. Ces sédiments vont être soumis, lors de leur enfouissement progressif dans le bassin, à des circulations de fluides qui vont les transformer. Cette succession de modifications est classiquement divisée en deux grandes étapes : la diagénèse précoce et la diagénèse tardive ou d'enfouissement. La diagénèse précoce, ou éogenèse, désigne le plus souvent la suite de transformations, ou d'interactions fluide-roche (superficielles) intervenant pendant ou juste après le dépôt d'un sédiment, avant que celui-ci ne soit recouvert par un autre sédiment. Cette relation directe avec l'interface eau-sédiment et la zone d'influence des fluides de surface (météorique lors d'émersion ou marin dans le cas des fonds durcis sous-aquatiques) implique également un rôle important des facteurs biologiques sur les processus diagénétiques. La diagénèse dite tardive désigne les transformations minérales des sédiments et roches plus ou moins compactées, longtemps après leur dépôt, liées à des circulations de fluides non superficielles. Elle comprend toute autre modification physico-chimique, à priori plus lente (compaction, transformation minéralogique, dissolution).

Il apparaît donc clairement que les circulations de fluide dans un bassin ont un impact majeur sur les transformations subies par les roches au cours de temps géologiques. Cet impact est particulièrement important dans le cas de dépôts carbonatés, car leur composition minéralogique les rend particulièrement sensibles à l'altération chimique, et cause une grande diversité de réactions diagénétiques (dissolution, précipitation, recristallisation...). La zone marine constamment ennoyée par une eau généralement sursaturée vis à vis des espèces minérales carbonatées constitue un locus préférentiel de destruction de la porosité par les cimentations marines. Dans le cas particulier des contextes évaporatoires, la précipitation d'évaporites et les processus de dolomitisation (de sebkha et de reflux) vont localement se produire et affecter les propriétés initiales du sédiment. Sous conditions subaériennes (émersion des sédiments précédemment déposés), la présence d'eaux relativement diluées, pouvant montrer une large gamme de saturation vis à vis des minéraux carbonatés induits différents processus : dissolution, cimentation, néomorphisme (dissolution et précipitation locale avec modification de la minéralogie).

Ainsi, les processus intervenant au cours de la diagénèse d'une roche carbonatée ont pour effet de modifier les caractéristiques intrinsèques de la roche (nature et géométrie des grains formant la matrice de la roche ; nature et géométrie des pores de la roche), et de fait, les propriétés pétrophysiques et mécaniques de la roche carbonatée.

De manière générale, les transformations diagénétiques subies par une roche au cours du temps ont pour conséquence la variation au cours des temps géologiques de la composition minéralogique, des propriétés pétrophysiques (porosité, perméabilité par exemple) et mécaniques des roches (modules élastiques). Ainsi, il apparaît clairement qu'une simulation stratigraphique se doit, pour être la plus représentative de la réalité, de modéliser les effets diagénétiques induits par les circulations de fluide au cours de l'histoire géologique d'un bassin sédimentaire.

**Etat de la technique**

Les documents suivants seront cités dans la suite de la description :

Granjeon D. et Joseph P. (1999) Concepts and applications of a 3D multiple lithology, diffusive model in stratigraphic modeling. In: Harbaugh J. W., Watney W. L., Rankey E. C., Slingerland R., Goldstein R. H., Franseen E. K. (Eds.). Numerical Experiments in Stratigraphy: Recent Advances in Stratigraphic and Sedimentologic Computer Simulations. SEPM Special Publications, 62, p. 197-210.

Packhurst D. L. (1995) User's guide to PHREEQC - a computer program for speciation reaction-path, advection-transport and inverse geochemical calculations, Unisted States Geological Survey Water Resources Investigation Report 95-4227.

Vacher H.L. (1988) Dupuit-Ghyben-Herzberg analysis of strip-islands lenses: Geological Society of America, Bulletin, v. 100, p. 580-591.

Vacher H. L., Bengtsson T. O., Plummer L. N. (1990). Hydrology of meteoric diagenesis: residence time of meteoric ground water in island fresh-water lenses with application to aragonite-calcite stabilization rate in Bermuda. Geological Society of America Bulletin, 102, 223-232.

Whitaker F. F., Smart P., Hague Y., Waltham D., Bosence D. (1999). Structure and function of a coupled two-dimensional diagenetic and sedimentological model of carbonate platform evolution. In: Harbaugh J. W., Watney W. L., Rankey E. C., Slingerland R., Goldstein R. H., Franseen E. K. (Eds.). Numerical Experiments in Stratigraphy: Recent Advances in Stratigraphie and Sedimentologic Computer Simulations. SEPM Spécial Publications, 62, pp. 337-355.

Whitaker F. F., Smart P. L. (2007). Geochemistry of meteoric diagenesis in carbonate islands of the northern Bahamas: 2. Geochemical modelling and budgeting of diagenesis. Hydrological Processes, 21(7), pp. 967-982.

Whitaker F. F., Felce G. P., Benson G. S., Amour F., Mutti M., Smart P.L. (2014). Simulating flow through forward sediment model stratigraphies: insights into climatic control of reservoir quality in isolated carbonate platforms. Petroleum Geoscience, 20, pp. 27-40.

On connait les documents :

- ALBERTO CONSONNI ET AL ET AL, 2009, "Application of numerical modelling to a case of compaction-driven dolomitization: a Jurassic palaeohigh in the Po Plain, Italy", SEDIMENTOLOGY, vol. 57, no. 1, 1 janvier 2010 (2010-01-01), pages 209-231, XP055448783, ISSN: 0037-0746, D01: 10.1111/j.1365-3091.2009.01103,
qui décrit une simulation numérique visant à modéliser les effets d'une dolomitisation d'une plateforme carbonatée, cette simulation numérique comprenant une simulation de bassin et une simulation de transport réactif.

- YITIAN XIAO ET AL:, 2006, "Reactive transport modeling of carbonate and siliciclastic diagenesis and reservoir quality prédiction", 2006 ABU DHABI INTERNATIONAL PETROLEUM EXHIBITION AND CONFERENCE, 5 novembre 2006 (2006-11-05), XP055449495,
qui décrit une simulation de transport réactif pour modéliser des effets de la diagénèse dans des roches carbonatées et siliclastiques.

On connaît le document (Whitaker *et al*., 1999) qui décrit une simulation simplifiée des effets de la présence de fluides sur l'évolution de la minéralogie et de la porosité de dépôts sédimentaires carbonatés. Plus précisément, les auteurs décrivent un modèle hydrologique l'évolution géochimique des eaux souterraines (c'est-à-dire l'évolution de la composition chimique des eaux souterraines) dans chaque zone hydrologique n'est pas considérée. De plus, dans ce modèle, aucun transport de fluide à l'intérieur d'une hydrozone n'est considéré, ce qui n'est pas réaliste, notamment dans le cas de l'hydrozone de type phréatique. Par conséquent, la diagénèse est supposée uniforme dans ces zones. Et enfin, ces modèles hydrologiques et diagénétiques ne sont pas couplés à une simulation stratigraphique, c'est-à-dire que le résultat de ces simulations n'est pas utilisé comme paramètres d'entrée et/ou contraintes de la simulation stratigraphique, et réciproquement.

On connaît également le document (Whitaker et Smart, 2007) qui décrit une amélioration des précédentes lois cinétiques de transformation minéralogique, via une modélisation géochimique 0D, toutefois non couplée à une simulation stratigraphique. En particulier, cette approche améliorée repose sur le modèle PHREEQC (Parkhurst, 1995) pour définir des lois dans chacune des hydrozones, fonction de différents paramètres tels que l'épaisseur des zones vadose et phréatique, la $PCO_2$, le flux d'eau météorique, la porosité, l'évapotranspiration, l'oxydation et le mélange des eaux (uniquement à l'interface vadose/phréatique). Les lois cinétiques définies sont linéaires, affectées à chaque hydrozone, voire à des parties d'hydrozone (le sommet de la nappe phréatique par exemple) et ne tiennent pas compte des effets cinétiques potentiels. De même, aucun transport de fluide n'est modélisé dans cette approche.

On connaît également le document (Whitaker et al., 2014) qui décrit une modélisation stratigraphique prenant en compte des effets de la diagénèse météorique (diagenèse précoce se déroulant lors de l'émersion de sédiments carbonatés, liée à des eaux douces dites « météoriques ») subis par les carbonates. Plus précisément, cette approche permet de prédire la distribution des propriétés pétrophysiques (perméabilité et porosité) pré-enfouissement en simulant la distribution des faciès de dépôts d'une plateforme carbonatée isolée (c'est-à-dire une plateforme non alimentée par des flux hydrologiques venus du continent, telle qu'une île) et la diagenèse météorique subie par ces faciès. Dans cette approche, les hydrozones sont définies de la même manière que dans les études précédentes, ainsi que les taux de transformation minéralogique qui peuvent varier localement au sein de chaque hydrozone tel que décrit dans (Whitaker et smart, 2007). Par exemple, les auteurs montrent qu'en climat semi-aride, les sols sont peu développés, l'épaisseur de la zone vadose est faible et l'évapotranspiration est limitée, ce qui conduit à la précipitation de calcite dans la zone vadose et dans les premiers mètres à proximité du niveau de la nappe. Toutefois, cette approche ne modélise pas l'influence d'une circulation de fluide, notamment latérale.

Ainsi, de manière générale, les approches décrites dans les documents de l'art antérieur utilisent un modèle hydrologique simple, ne comprenant pas la modélisation d'un aquifère et de manière plus générale, d'un flux hydrologique amont-aval. Ainsi, ce type d'approche n'est applicable qu'à des configurations morphologiques de type plateforme carbonatée isolée et n'est pas généralisable aux autres types de plateformes (attachées, barrées...), pour lesquelles la prise en compte d'un aquifère et d'un flux hydrologique amont-aval incluant un calcul de bilan de flux est nécessaire pour avoir un suivi complet de l'évolution de la chimie des eaux et donc des interactions fluides-roches. Cette approximation, si elle peut être acceptable lorsque la simulation de la diagénèse est limitée à un réservoir pétrolier (par exemple une plateforme carbonatée isolée), elle ne peut être valable à l'échelle du bassin sédimentaire, pour lequel les flux hydrologiques sont non négligeables au cours du temps, notamment les flux amont-aval de fluides.

La présente invention vise à pallier ces inconvénients au moyen d'une simulation stratigraphique couplée à un modèle hydrologique et à modèle diagénétique définis de manière à prendre en compte les flux hydrologiques au sein d'un bassin sédimentaire, permettant ainsi de modéliser de façon plus réaliste l'évolution de la composition chimique des fluides circulant au sein du bassin et donc les interactions fluides-roches au cours des temps géologiques.

## Le procédé selon l'invention

Ainsi, la présente invention concerne un procédé pour exploiter des hydrocarbures au sein d'un bassin sédimentaire, ledit bassin résultant d'une succession de dépôts sédimentaires au cours du temps, au moins une partie desdits dépôts sédimentaires ayant été soumis à des circulations de fluides, ledit procédé étant mis en œuvre à partir de mesures de propriétés relatives à la stratigraphie et à l'hydrologie dudit bassin et au moyen d'un simulateur stratigraphique exécuté sur ordinateur, ledit simulateur stratigraphique permettant la détermination d'une représentation maillée représentative de la stratigraphie dudit bassin pour une succession de pas de temps. Selon l'invention, pour au moins un pas de temps :

A. au moyen dudit simulateur et de paramètres dudit simulateur pour ledit pas de temps construits à partir desdites mesures, on détermine ladite représentation maillée représentative de la stratigraphie dudit bassin pour ledit pas de temps, chacune des mailles de ladite représentation maillée comprenant au moins une composition minéralogique et une porosité ;

B. au moyen d'un modèle hydrologique et de paramètres dudit modèle hydrologique construits à partir desdites mesures et de ladite représentation maillée déterminée au moyen dudit simulateur pour ledit pas de temps, on délimite au moins une zone hydrologique au sein dudit bassin pour ledit pas de temps et on détermine en chacune des mailles de la représentation maillée situées dans ladite zone au moins une composition chimique desdits fluides et une direction de circulation desdits fluides dans ladite zone ;

C. on met à jour au moins ladite composition chimique desdits fluides, ladite composition minéralogique et ladite porosité en chacune des mailles de ladite représentation maillée au moyen d'un modèle diagénétique comprenant :

i. un bilan des flux hydrologiques, établi au moyen au moins desdites directions de circulation desdits fluides, à partir duquel on détermine un ordre de parcours desdites mailles par lesdits fluides ;

ii. un modèle cinétique réactionnel modélisant les interactions entre ladite composition chimique desdits fluides et ladite composition minéralogique dans ladite maille ;

ladite composition chimique desdits fluides en entrée dudit modèle diagénétique correspondant à ladite composition chimique desdits fluides pour ledit pas de temps précédent dans ladite succession desdits pas de temps.

Puis, à partir au moins de ladite composition minéralogique et de ladite porosité mises à jour pour au moins ledit pas de temps, on quantifie le potentiel pétrolier dudit bassin sédimentaire et/ou on définit un schéma d'exploitation dudit bassin, et on exploite ledit bassin sédimentaire en fonction de ladite quantification et/ou dudit schéma.

Selon une réalisation de l'invention, à partir de ladite composition minéralogique et de ladite porosité mises à jour, et au moyen d'une méthode d'homogénéisation, on peut déterminer en sus une perméabilité et/ou un coefficient de Poisson et/ou un module d'Young en chacune des mailles de ladite représentation maillée pour ledit pas de temps.

Selon une mise en œuvre de l'invention, ledit modèle hydrologique peut implémenter une équation de Navier-Stokes modifiée en ce que la vitesse de transport desdits fluides est conditionnée par des gradients de pression.

Selon une variante de réalisation de l'invention, on peut délimiter une pluralité de zones hydrologiques au moyen dudit modèle hydrologique et on peut déterminer en sus une direction de circulation desdits fluides entre lesdites zones hydrologiques.

Selon une mise en œuvre de l'invention selon laquelle au moins une zone hydrologique de type zone vadose est délimitée au moyen dudit modèle hydrologique, on peut attribuer une direction de circulation desdits fluides verticale dans lesdites mailles de ladite zone vadose.

Avantageusement, ledit ordre de parcours dans ladite zone vadose peut être organisé d'une maille à une maille sous-jacente à l'intérieur d'une colonne de mailles situées dans ladite zone vadose, et de manière indépendante d'une colonne de mailles à une autre colonne de mailles situées dans ladite zone vadose.

Selon une mise en œuvre de l'invention selon laquelle au moins une zone hydrologique de type zone phréatique a été délimitée au moyen dudit modèle hydrologique, on peut attribuer une direction de circulation desdits fluides latérale dans lesdites mailles de ladite zone phréatique.

Préférentiellement, ledit ordre de parcours dans ladite zone phréatique peut être organisé colonne de mailles par colonnes de mailles, et ladite composition desdits fluides entrant dans une desdites colonnes de ladite zone phréatique peut être fonction de ladite composition desdits fluides moyenne dans ladite colonne de mailles située en amont.

Selon une variante de réalisation de l'invention dans laquelle ledit bassin comprend au moins un dépôt sédimentaire de type évaporite sus-jacent à un dépôt sédimentaire de type carbonaté, ledit modèle cinétique réactionnel peut tenir compte du rapport Magnésium sur Calcium de ladite composition chimique desdits fluides en chacune desdites mailles.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

D'autres caractéristiques et avantages du procédé selon l'invention, apparaîtront à la lecture de la description ci-après d'exemples non limitatifs de réalisations, en se référant aux Figures annexées et décrites ci-après.

**Présentation succincte des figures**

-   La Figure 1A présente un exemple de représentation maillée issue de la mise en œuvre d'une simulation stratigraphique pour un bassin sédimentaire donné et pour un pas de temps donné.

-   La Figure 1B présente des zones hydrologiques identifiées au moyen du modèle hydrologique selon l'invention pour le bassin sédimentaire et le pas de temps considérés en Figure 1A.

-   La Figure 1C présente l'évolution de la composition minéralogique et de la porosité pour le pas de temps considéré en Figures 1A et 1B et pour trois colonnes de mailles présentées en Figure 1B, évolution déterminée au moyen du modèle diagénétique selon l'invention.

- La Figure 2 illustre schématiquement la mise en œuvre d'un mode de réalisation du modèle diagénétique selon l'invention dans le cas d'un bassin sédimentaire présentant une zone vadose, une zone phréatique et une zone de mélange eau de mer/eau douce.

**Description détaillée du procédé**

De façon générale, l'un des objets de l'invention concerne un procédé pour exploiter les hydrocarbures présents au sein d'un bassin sédimentaire, comprenant au moins trois simulations couplées : une simulation stratigraphique de l'évolution stratigraphique d'un bassin sédimentaire, une simulation hydrologique délimitant des zones hydrologiques, et une simulation des effets diagénétiques engendrés par des flux hydrologiques (par exemple de direction verticale et/ou latérale) intervenant au sein du bassin au cours des temps géologiques. Selon une mise en œuvre de l'invention, les simulations stratigraphique, hydrologique et diagénétique sont réalisées selon trois étapes séquentielles, ou bien, alternativement, les modèles sur lesquels reposent les simulations stratigraphique, hydrologique et diagénétique sont résolus simultanément.

De manière générale, un bassin sédimentaire est formé par des dépôts de sédiments successifs dans le temps. Ces dépôts sédimentaires sont notamment soumis à des circulations de fluides au cours des temps géologiques, circulations de fluides qui contribuent à une modification des propriétés de ces dépôts. La présente invention vise à quantifier ces modifications, et en particulier au moins les changements de composition minéralogique et de porosité, au moyen d'une simulation stratigraphique selon l'art antérieur, couplée à un modèle hydrologique et à un modèle diagénétique. Selon une mise en œuvre de l'invention, on détermine en sus d'autres propriétés pétrophysiques (telles que la perméabilité) et/ou des propriétés mécaniques (telles que le module d'Young et le coefficient de Poisson) du bassin sédimentaire.

La présente invention est particulièrement appropriée dans le cas de dépôts carbonatés et évaporitiques soumis à des flux hydrologiques, mais peut être toutefois appliquée à tout type de dépôt tel que des dépôts clastiques.

La présente invention requiert de disposer de :

- de mesures relatives à la stratigraphie du bassin étudié : il s'agit de mesures réalisées in situ, permettant notamment de déterminer l'architecture du bassin à l'actuel, de qualifier les différents dépôts sédimentaires (composition minéralogique, épaisseurs, âges, conditions de dépôts etc) ou encore les événements géologiques subies par ces dépôts sédimentaires (fracturation, érosion, subsidence, etc). Ces mesures peuvent consister en des études d'affleurements et/ou d'analogue, en des mesures diagraphiques réalisées le long de puits forés dans le bassin étudié, en des échantillons de roche prélevés par exemple par carottage, en des images sismiques obtenues suite à des campagnes d'acquisition sismique. A partir des mesures ainsi réalisées, on peut définir les paramètres d'entrée d'une simulation stratigraphique, tels que la morphologie du bassin, les apports en sédiments (inorganiques, tels que la production des différents carbonates, et éventuellement organiques), leur transport pour chaque pas de temps. Par exemple, la morphologie pour un pas temps donné peut être obtenue à partir de la morphologie mesurée à l'actuel (sur une image sismique par exemple) et au moyen d'une restauration structurale, technique bien connue du spécialiste, qui peut par exemple être réalisée au moyen du logiciel KronosFlow (IFP Energies nouvelles, France). De même, les apports en sédiments pour un pas de temps donné peuvent être déterminés à partir du volume de la couche sédimentaire observée à l'actuel, divisé par la durée de la sédimentation. Enfin, les paramètres de transport pour un pas de temps donné peuvent être estimés à partir de profils de dépôts établis à partir de l'observation du bassin au temps actuel. Ces mesures peuvent également permettre de définir des paramètres d'entrée du modèle hydrologique et du modèle diagénétique selon l'invention.

- de mesures relatives à l'hydrologie du bassin : il s'agit de mesures réalisées in situ, permettant notamment de qualifier des paramètres hydrologiques du bassin, à l'actuel et de manière préférée pour des temps géologiques antérieurs. A l'actuel, il peut s'agir de mesures de la pluviométrie, de l'évaporation, des flux des aquifères du bassin étudié. Pour des temps géologiques antérieurs, on peut par exemple extrapoler les mesures actuelles à partir de la connaissance des climats antérieurs déduite de l'observation du bassin à l'actuel, ou on peut supposer que les paramètres de transport sont équivalents à ceux des fleuves actuels, et que la pluviométrie et l'évaporation sont définies en se référant aux zones climatiques actuelles. Ces mesures permettent notamment de définir les paramètres de transport nécessaires à une simulation stratigraphique, mais également de définir des paramètres du modèle hydrologique et du modèle diagénétique selon l'invention.

- un simulateur stratigraphique : il s'agit d'un logiciel exécuté sur ordinateur visant à reconstituer les processus sédimentaires ayant affecté le bassin depuis un temps géologique t jusqu'au temps actuel. Une simulation stratigraphique numérique est de manière générale implémentée de manière discrète dans le temps, c'est-à-dire qu'une simulation stratigraphique simule l'état stratigraphique du bassin pour une succession de pas de temps. Un pas de temps d'un simulateur stratigraphique correspond à une durée géologique au cours de laquelle des dépôts ou des érosions sédimentaires ont été enregistrées. Les propriétés (dont la porosité et la minéralogie) de ces dépôts peut être relativement hétérogènes au niveau du bassin. La simulation de l'histoire du remplissage d'un bassin sédimentaire est réalisée à partir des paramètres d'entrée représentatifs de l'histoire sédimentaire du bassin étudié. Selon une mise en œuvre de l'invention, les paramètres d'entrée d'une simulation stratigraphique sont au moins (1) l'espace disponible pour la sédimentation, lié à des mouvements tectoniques et/ou eustatiques et à la compaction mécanique des sédiments (ou tassement des sédiments sous l'effet du poids des couches sus-jacentes) (2) l'apport en sédiments dans le bassin, soit par les frontières, soit par l'intermédiaire d'une production ou d'une précipitation *in situ*, (3) le transport de ces sédiments (capacité de transport estimée à partir des caractéristiques du sédiment comme la taille des grains ou encore leur densité, du flux d'eau s'écoulant à la surface du sol et de la pente locale du bassin) dans l'espace disponible créé. Le système d'équations décrivant ces processus peut par exemple être résolu par une discrétisation spatiale en volume fini, et un schéma explicite en volumes finis. Selon l'invention, le résultat d'une simulation stratigraphique pour un pas de temps correspond à une représentation maillée pour laquelle chaque maille est au moins remplie par les informations suivantes : composition minéralogique et porosité des sédiments. De manière très classique, la représentation maillée issue d'une simulation stratigraphique est aussi renseignée avec des propriétés caractéristiques de l'environnement de dépôt (profondeur de l'eau, élévation du bassin, ...) et est renseignée en faciès. On peut trouver une description d'un tel simulateur stratigraphique dans le document (Granjeon et Joseph, 1999). Un exemple d'un tel simulateur stratigraphique est le logiciel DionisosFlow (IFP Energies nouvelles, France). Par ailleurs, le simulateur stratigraphique selon l'invention ne modélise pas les phénomènes de diagénèse liés à des transports de fluide.

Selon une mise en œuvre de l'invention, le procédé selon l'invention comporte au moins les étapes 1) à 4) suivantes, l'enchainement des étapes 1) à 3) étant appliqué pour au moins un pas de temps de la simulation stratigraphique. Alternativement, les étapes 1) à 3) sont réalisées simultanément, ce qui signifie que les modèles sur lesquels reposent ces étapes sont résolus simultanément. Cette alternative permet une plus grande efficacité en termes de temps de calcul et/ou d'éviter que la solution de l'un des modèles soit fonction de la solution d'un modèle résolu à l'étape précédente.

**1. Simulation stratigraphique**

**2. Détermination de zones hydrologiques**

**3. Détermination des effets diagénétiques**

**4. Exploitation des hydrocarbures de la formation**

De manière préférée, les étapes 1) à 3) sont répétées pour chaque pas de temps de la simulation stratigraphique. Avantageusement, les étapes 1) à 3) sont au moins répétées pour chaque pas de temps de la simulation stratigraphique pour lesquels une simulation des effets diagénétiques sur les dépôts sédimentaires liés à des flux hydrologiques est souhaitée.

**1. Simulation stratigraphique**

Il s'agit au cours de cette étape de simuler les dépôts sédimentaires au sein du bassin étudié pour le pas de temps considéré. Cette étape est réalisée au moyen d'un simulateur stratigraphique tel que décrit ci-dessus, à partir de paramètres de simulation stratigraphique tels que décrits ci-dessus ; ces paramètres étant déterminés au moins à partir de mesures relatives à la stratigraphie et à l'hydrologie du bassin étudié tels que décrites ci-dessus.

Selon un mode de réalisation de l'invention, on met en œuvre cette étape au moyen d'un simulateur stratigraphique tel que celui décrit dans le document (Granjeon et Joseph, 1999). Un exemple d'un tel simulateur stratigraphique est le logiciel DionisosFlow (IFP Energies nouvelles, France).

Selon l'invention, à l'issue de cette étape, on obtient une représentation maillée représentative de la stratigraphie du bassin pour le pas de temps considéré, chacune des mailles de cette représentation étant renseignée au moins en termes de composition minéralogique et de porosité initiale, éventuellement modifiée par l'effet de la compaction mécanique. Selon une mise en œuvre de l'invention, chacune des mailles de la représentation maillée est également renseignée en environnement de dépôt et en faciès.

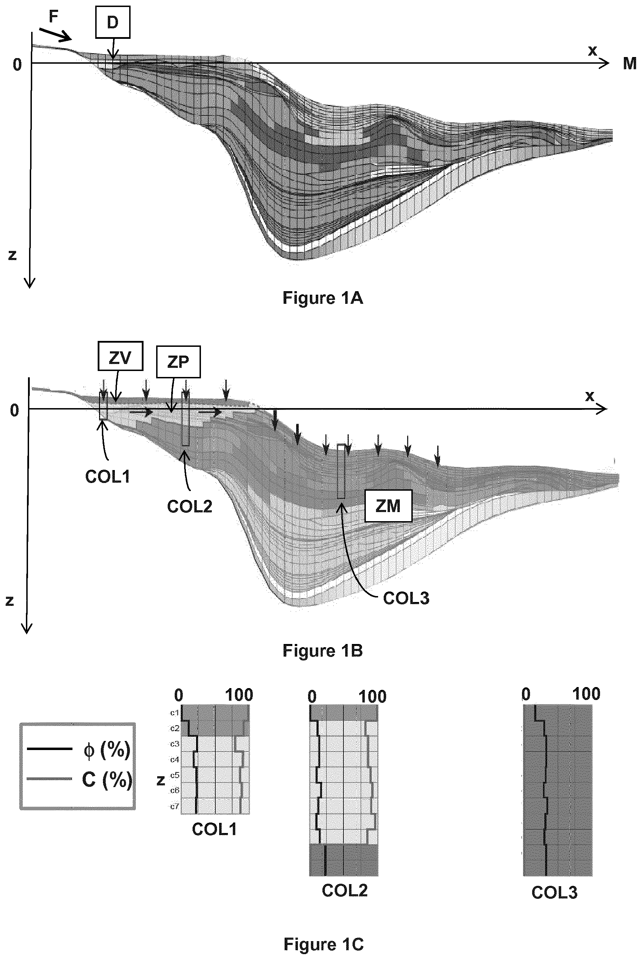

A titre purement illustratif, la Figure 1A présente une section verticale au sein d'une représentation maillée issue d'une simulation stratigraphique pour un pas de temps donné. On peut observer sur cette figure que l'architecture du bassin étudié pour le pas de temps considéré est en forme de cuvette dans laquelle se sont déposés des sédiments successifs, une partie de ces sédiments ayant été apportés dans le bassin par un fleuve F, au moins une partie du bassin étant situé sous le niveau de la mer M. La simulation stratigraphique pour le pas de temps considéré a permis de simuler le dépôt sédimentaire D (couche de mailles la plus en surface du bassin).

## 2. Détermination de zones hydrologiques

Au cours de cette étape, il s'agit de définir au moins une zone hydrologique au sein du bassin étudié pour le pas de temps considéré, au moyen d'un modèle hydrologique et de paramètres d'entrée du modèle hydrologique.

Au sens de l'invention, une zone hydrologique est une zone ayant des propriétés hydrologiques (au moins la composition chimique des fluides et la direction de la circulation des fluides) pouvant être considérées comme relativement homogènes dans l'espace pour le pas de temps considéré.

Classiquement, les différents types de zones hydrologiques sont :

- Les zones marines, à salinité normale (c'est-à-dire voisine de la salinité moyenne de l'eau de mer, autour de 30 à 35 g/l) et à circulation de fluides essentiellement verticale et limitée aux premiers mètres de sédiments (sous l'interface eau-sédiment). Selon une mise en œuvre de l'invention, la circulation des fluides dans une telle zone peut être représentée par un flux vertical de valeur décroissante ;

- Les zones côtières restreintes (lagunes, lagons, lacs côtiers), dans lesquelles la salinité du fluide peut varier drastiquement de la salinité marine normale (salinité légèrement inférieure à la salinité marine, et autour de 10 à 30 g/l), depuis des conditions saumâtres à des conditions hypersalines (salinité très supérieure à la salinité marine, pouvant dépasser 50 à 100 g/l). Selon une mise en œuvre de l'invention, la circulation de fluide au sein de ce type de zones peut être représentée par une percolation verticale et d'un flux latéral liés au reflux des saumures.

- Les zones continentales, soumises à un flux de fluide météorique (c'est-à-dire d'origine non marine). De manière classique, les zones continentales sont elles-mêmes décomposées en :

  ◦ une zone vadose météorique, non-saturée en eau, et pour laquelle la circulation des fluides peut être représentée selon une mise en œuvre de l'invention comme essentiellement verticale (percolation des précipitations d'eau douce) ;
  ◦ une zone phréatique météorique, saturée en eau douce et pour laquelle la circulation des fluides peut être représentée selon une mise en œuvre de l'invention comme essentiellement latérale ;
  ◦ une zone de mélange, formée d'eau de mer et d'eau douce, à circulation de fluide limitée, et qui peut être représentée par une valeur de flux nulle selon une mise en œuvre de l'invention.

Selon l'invention, plusieurs zones hydrologiques du même type peuvent co-exister dans un bassin sédimentaire à un pas de temps donné.

De manière générale, les paramètres d'entrée du modèle hydrologique sont déterminés à partir d'au moins une partie des mesures relatives à la stratigraphie et à l'hydrologie du bassin telles que décrites précédemment, et d'au moins une partie des informations présentes dans la représentation maillée à l'issue de l'étape précédente.

Selon une mise œuvre de l'invention, les paramètres d'entrée du modèle hydrologique peuvent comprendre la morphologie (topographie, limites de couches géologiques etc) du bassin, la porosité et la perméabilité au sein de chaque maille de la représentation maillée, le climat moyen au pas de temps considéré (pluie et évapotranspiration). La perméabilité dans une maille peut être déterminée à partir de la composition minéralogique et de la porosité issues de la simulation stratigraphique pour le pas de temps, ainsi que d'une connaissance du faciès présent dans la maille (qui est de manière classique également une sortie d'une simulation stratigraphique) et au moyen d'une méthode d'homogénéisation telle que décrite dans la demande de brevet EP 3104199 (US 6423664). La perméabilité dans une maille peut être également déterminée par le spécialiste à partir de ses connaissances générales sur le bassin.

De manière préférée, les zones hydrologiques sont déterminées en trois dimensions, à l'échelle du bassin sédimentaire. Selon une mise en œuvre de l'invention, la distribution et la géométrie des différentes zones hydrologiques peuvent être déterminées à l'aide du modèle hydrologique de Dupuis-Forcheimer, qui repose sur une intégration le long des verticales de l'équation de Navier-Stokes et dans lequel la vitesse de transport de l'eau dans le sous-sol (et par conséquence le niveau des nappes) est conditionnée par les gradients de pression dans le sous-sol. Plus précisément, on peut définir un modèle hydrologique reposant sur une équation du type :

$$S_s \frac{\partial h}{\partial t} - \nabla \cdot (K \nabla h) = Q$$

avec :

- $h$ la charge hydraulique [L],

- $t$ le temps [T],

- $K$ le tenseur symétrique de conductivité hydraulique (ou perméabilité) [L.T$^{-1}$],

- $S_s$ le coefficient d'emmagasinement spécifique [L$^{-1}$],

- $Q'$ un terme source d'extraction (pompage) [T$^{-1}$].

Le terme source Q d'extraction correspond à la recharge en eau (ou au pompage) de la nappe par les précipitations diminuées de l'évapotranspiration, ainsi qu'aux apports en eau aux frontières de la zone simulée (apport des zones amont et export vers les zones aval). Selon cette mise en œuvre de l'invention, le substratum du bassin sédimentaire est supposé imperméable. La résolution de cette équation permet de déterminer les propriétés hydrauliques (charge hydraulique et vitesse d'écoulement) en tout point du bassin. L'élévation du toit de la nappe phréatique, qui sépare la zone phréatique de la zone vadose, et les gradients de pressions sont déduits des charges calculées. Une telle réalisation du modèle hydrologique permet notamment la détermination du niveau des nappes phréatiques à l'état stationnaire, et donc par exemple de diviser la zone continentale d'un bassin sédimentaire en une zone vadose météorique, une zone phréatique météorique et une zone de mélange eau de mer/eau douce.

Selon l'invention, une fois les zones hydrologiques délimitées, on attribue à chacune des mailles de la représentation maillée du bassin une composition chimique des fluides présents dans la maille et une direction de circulation des fluides, en entrée de la maille et/ou en sortie de la maille.

Selon une mise en œuvre de l'invention, la direction de circulation des fluides dans la maille considérée est définie par le type de zone hydrologique auquel appartient la maille considérée. Selon une mise en œuvre de l'invention, dans le cas où la maille considérée est voisine d'une maille appartenant à une zone hydrologique de type différent, on peut en outre définir une direction de circulation des fluides entre ces mailles de type hydrologique différent.

Selon une mise en œuvre de l'invention pour laquelle les étapes 1) à 3) ont été préalablement appliquées pour au moins au pas de temps précédent de la simulation, la composition des fluides en entrée du modèle diagénétique pour le pas de temps considéré correspond à la composition des fluides déterminée à l'issue de l'application des étapes 1) à 3) pour le pas de temps précédent.

Selon une mise en œuvre de l'invention pour laquelle les étapes 1) à 3) n'ont pas été préalablement appliquées à un pas de temps précédent, la composition chimique initiale des fluides au sein d'une zone hydrologique donnée pour le pas de temps considéré est prédéfinie par un spécialiste, en fonction de la zone hydrologique considérée et des mesures relatives à l'hydrologie du bassin telles que décrites ci-dessus. Le spécialiste a parfaite connaissance de moyens pour initialiser une telle composition chimique pour chacune des zones hydrologiques identifiées.

Selon une mise en œuvre de l'invention, la composition chimique des fluides présents au sein d'une maille est par exemple décrite par la saturation de ces fluides vis-à-vis des minéraux carbonatés, l'alcalinité et la pression partielle en $CO_2$ aqueux.

A titre purement illustratif, la Figure 1B présente un exemple de mise en œuvre d'un modèle hydrologique pour le même bassin et pour le même pas de temps que ceux considérés à la Figure 1A. Ainsi le bassin étudié, pour ce pas de temps, comporte plusieurs zones hydrologiques : une zone vadose météorique ZV, une zone phréatique météorique ZP et une zone de mélange ZM eau de mer/eau douce. Sur cette Figure 1B sont également présentées sous la forme de flèches les directions principales des flux hydrologiques dans chacune de ces zones (direction verticale pour la zone vadose ZV, latérale pour la zone phréatique ZP, à circulation nulle pour la zone de mélange ZM), ainsi que l'emplacement de trois colonnes de mailles : les colonnes COL1 et COL2 qui traversent à la fois la zone vadose ZV et la zone phréatique ZP, la colonne COL2 étant plus en aval (par rapport à la direction du flux dans la zone phréatique) que la colonne COL1, et la colonne COL3 traversant uniquement la zone de mélange ZM.

## 3. Détermination des effets diagénétiques

Au cours de cette étape, il s'agit de déterminer au moins l'évolution de la composition minéralogique et de la porosité induite par les circulations de fluides dans le bassin étudié pour le pas de temps considéré. Selon l'invention, cette modélisation est réalisée au moyen d'un modèle diagénétique tenant compte des directions de circulation des fluides dans le bassin telles que déterminées à l'étape précédente, et d'un modèle cinétique réactionnel modélisant les interactions entre composition chimique des fluides et composition minéralogique dans chacune des mailles de la représentation maillée. Ainsi, selon l'invention, la composition chimique des fluides est également mise à jour en chaque maille de la représentation maillée, du fait des interactions fluides/minéraux dans la maille, mais aussi du fait que les fluides circulent d'une maille à une autre.

Selon l'invention, le modèle diagénétique comprend :

- un bilan de flux hydrologique, établi au moins pour chacune des zones hydrologiques, et tenant compte des directions de circulation des fluides identifiées à l'étape précédente, et à partir duquel on détermine un ordre de parcours des mailles de la représentation maillée suivi par les fluides circulant dans le bassin étudié ;
- un modèle cinétique réactionnel, modélisant les interactions entre la composition chimique des fluides et la composition minéralogique des sédiments, le long du parcours suivi par les fluides identifié au moyen du bilan de flux hydrologique.

Ainsi, selon l'invention, le modèle diagénétique est adapté en fonction du type de zone hydrologique, chaque zone ayant des directions de circulation des fluides propres (par exemple une direction essentiellement verticale dans la zone vadose, soumise essentiellement à la percolation des précipitations ; une direction essentiellement latérale dans une zone phréatique) et ayant des caractéristiques en termes de composition chimique des fluides similaires (eau douce dans la zone vadose ; eau de mer dans une zone marine). Le déséquilibre chimique entre le fluide et la minéralogie dans chaque maille d'une zone hydrologique donnée génère une modification de la porosité et de la minéralogie initiale dans cette maille, fonction de cinétiques réactionnelles basées sur des lois quantitatives phénoménologiques adaptées aux échelles de temps et d'espace considérées pour chaque processus diagénétique.

Selon une mise en œuvre de l'invention, on utilise le modèle cinétique réactionnel développé dans le document (Vacher et al., 1990). En particulier, ce document décrit que la cinétique d'une réaction diagénétique représentant l'évolution au cours du temps de la proportion d'un minéral A (dans la totalité de l'assemblage minéralogique) peut être considérée plus ou moins analogue à une loi de décroissance exponentielle du premier ordre, ce qui peut s'exprimer sous la forme :

$$dC_A / dt = -kC_A$$

$$C_A = C_{A_0} \exp(-kt)$$

$$t_{1/2} = -\ln(2) / k$$

où $dC_A/dt$ représente la vitesse de dissolution de A, $C_A$ et $C_{A0}$ les concentrations de A ($cm^3/m^3$) aux temps t (années) et au début du processus, k et $t_{1/2}$ étant respectivement les constante réactionnelle et la demi-vie de A correspondante. Selon une mise en œuvre de l'invention, ces évolutions sont déterminées pour les trois minéraux carbonatés principaux, c'est-à-dire l'aragonite, la calcite et la dolomite.

Par rétroaction, la chimie du fluide entrant dans la maille considérée est modifiée en sortie, en fonction des cinétiques. Cette composition chimique modifiée du fluide est ensuite transportée d'une maille à une autre d'une même zone hydrologique, en fonction de l'ordre de parcours des mailles déterminé à partir du bilan de flux hydrologiques. Selon une mise en œuvre de l'invention, cette composition chimique modifiée du fluide dans une zone hydrologique donnée est également transportée à une zone hydrologique voisine, par exemple verticalement et/ou latéralement.

Selon une mise en œuvre de l'invention, le bilan de flux hydrologique peut être réalisé de la manière suivante :

-   Pour une zone météorique vadose, seuls les flux verticaux sont considérés. Le flux vertical entrant provient directement de l'infiltration des eaux de surface et le flux sortant résulte d'un transfert direct de ces eaux de surface de la zone vadose vers la nappe phréatique.

-   Pour la nappe phréatique météorique, les flux latéraux calculés par le modèle hydrologique (cf. étape 2 décrite précédemment) sont intégrés le long de chaque vertical pour définir le flux horizontal d'eau, auquel on additionne ensuite le flux vertical d'eau de surface s'écoulant de la zone vadose vers la zone phréatique sous-jacente, et auquel on soustrait le flux vertical s'échappant à la base de la zone phréatique pour rejoindre les zones hydrologiques plus profondes.

Selon une mise en œuvre de l'invention, à partir de ce bilan de flux hydrologique, on détermine un ordre préférentiel de parcours des mailles pour les fluides circulant dans le bassin tel que :

-   dans une zone de type vadose : on détermine un ordre de parcours des mailles selon lequel les fluides circulent indépendamment d'une colonne de mailles à une autre, et dans lequel, pour une colonne donnée, les fluides circulent d'une maille donnée de cette colonne vers une maille directement sous-jacente, incluant la première maille de la zone phréatique pour la colonne considérée ;

-   dans une zone de type phréatique : on détermine un ordre de parcours des mailles selon lequel les fluides dans cette zone circulent d'une colonne de mailles donnée à une colonne de mailles située en aval, la direction avale étant déterminée par la direction du flux dans la zone phréatique. Selon une mise en œuvre de l'invention, le déplacement latéral des fluides entre deux colonnes adjacentes s'effectue de mailles à mailles, ou, alternativement, la composition chimique des fluides déterminée pour les mailles d'une colonne situées dans la zone phréatique est moyennée avant son transfert à la colonne de mailles suivante.

Selon une mise en œuvre de l'invention, le modèle diagénétique permet de déterminer la proportion des trois minéraux carbonatés principaux dans chaque maille de la représentation maillée en fonction de la composition minéralogique initiale et de la durée du pas de temps selon les réactions suivantes :

-   l'aragonite présente initialement est modifiée en calcite et/ou la porosité initiale est augmentée ;

-   la calcite présente initialement est modifiée en dolomite et/ou la porosité initiale est augmentée ;

-   la dolomite 1 présente initialement est modifiée en dolomite 2.

Les réactions ainsi définies permettent de représenter respectivement la dissolution (partielle ou totale) de l'aragonite et sa transformation en calcite, la dissolution (partielle) de la calcite et sa transformation en dolomite, et enfin la recristallisation d'une dolomite.

Selon une mise en œuvre de l'invention, à partir de la composition minéralogique et de la porosité ainsi déterminées à l'issue du modèle diagénétique, et à partir d'une information texturale (par exemple de type faciès lithologique, qui est une sortie classique d'une simulation stratigraphique), on détermine en sus à l'issue de cette étape d'autres propriétés pétrophysiques (telle que la perméabilité) et/ou des propriétés mécaniques (telles que le module d'Young et le coefficient de Poisson) du bassin sédimentaire. On peut pour ce faire mettre en œuvre une méthode d'homogénéisation telle que décrite dans la demande de brevet EP 3104199 (US 6423664).

A titre purement illustratif, la Figure 1C présente un exemple de mise en œuvre d'un modèle diagénétique pour le même bassin et pour le même pas de temps que ceux considérés aux Figures 1A et 1B. Ainsi, la Figure 1C montre de gauche à droite l'évolution de la porosité $\phi$ et du pourcentage de calcite C le long respectivement des trois colonnes de mailles COL1, COL2 et COL3 présentées en Figure 1B. Ainsi, on peut observer sur cette Figure 1C, que les colonnes COL1 et COL2 se trouvent totalement ou partiellement au sein des hydrozones météoriques. La circulation verticale *per descensum* au sein de la zone vadose ZV permet 1) de représenter la percolation des précipitations au sein de cette zone ; 2) de calculer la recharge verticale de la zone phréatique ; 3) de modifier les minéralogies et porosité des mailles de la colonne spécifique à la zone vadose. La circulation latérale au sein de la zone phréatique ZP permet de représenter 1) la circulation au sein de la nappe phréatique ; 2) de modifier de manière incrémentale la composition chimique du fluide ; 3) de répercuter ces changements de composition du fluide sur les minéralogies et porosité des mailles de la colonne spécifique à la zone phréatique. La colonne COL3, se trouve intégralement en zone marine ZM et voit la porosité des mailles affectée par des processus de cimentation uniquement au sein des premières mailles sous l'interface eau-sédiment.

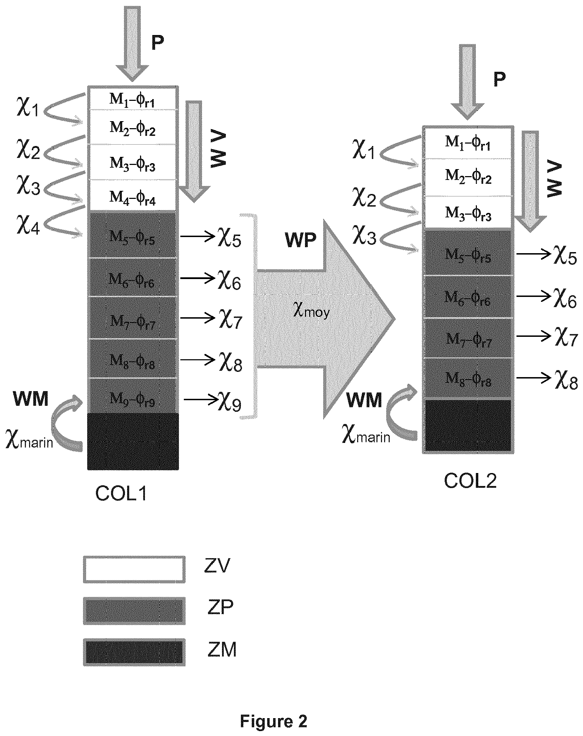

Selon un premier mode principal de réalisation de l'invention dans lequel le bassin sédimentaire comprend au moins une zone hydrologique de type continental, le modèle diagénétique peut rendre compte des effets induits par des circulations de fluides de directions variables suivant la zone hydrologique considérée : percolation verticale pour les fluides de la zone vadose (dues aux précipitations) et flux latéral pour les fluides dans la zone phréatique. Le modèle diagénétique peut être mis en œuvre de la façon suivante pour ce premier mode principal de réalisation de l'invention et tel qu'illustré schématiquement par la Figure 2 :

- dans la zone vadose ZV: les modifications diagénétiques, incluant les modifications de la composition chimique des fluides, sont déterminées colonne de mailles par colonne de mailles, et indépendamment d'une colonne de mailles à une autre. Au sein d'une colonne (par exemple COL1 ou COL 2 en Figure 2), le passage d'une maille à une autre, *per descensum,* est porté par le flux d'eau (schématisé par la flèche WV en Figure 2) qui percole uniquement verticalement dans la zone vadose, ce flux vertical étant induit par les précipitations P à la surface du bassin. Les réactions diagénétiques qui interviennent dans la première maille (au sommet de la colonne) modifient : 1) la composition minéralogique $M_i$ et la porosité résiduelle $\phi_{ri}$ au sein de la maille i; 2) la composition chimique $\chi_i$ du fluide en sortie de cette maille i. Ainsi, la composition chimique du fluide entrant dans la cellule sous-jacente est fonction de la composition chimique du fluide dans les mailles sus-jacentes. Au bas de la zone vadose, la composition chimique du fluide qui passe dans la zone phréatique est ainsi la résultante de la composition chimique initiale du fluide et des modifications subies successivement dans chaque maille ainsi traversée par le flux vertical.

- Dans la zone phréatique ZP : les modifications diagénétiques, incluant les modifications de la composition chimique des fluides, sont déterminées colonne de mailles par colonne de mailles, puis les fluides ainsi modifiés pour une colonne donnée sont « transportés » à la colonne de mailles située en aval, la direction avale étant déterminée par la direction principale du flux hydrologique dans la zone phréatique. Plus précisément, on détermine la composition chimique $\chi_i$ des fluides, la composition minéralogique $M_i$ et la porosité résiduelle $\phi_{ri}$ pour chacune des mailles d'une colonne COL1 de la zone phréatique, puis on réalise une moyenne $\chi_{moy}$ sur les compositions chimiques $\chi_i$ des fluides présents dans les mailles de la zone phréatique pour la colonne COL1 considérée, puis on utilise (transfert schématisé par la flèche notée WP en Figure 2) cette composition chimique moyenne $\chi_{moy}$ en entrée de la colonne de mailles avale adjacente COL2. Selon une mise en œuvre de l'invention, la composition chimique du fluide entrant dans les mailles d'une colonne située dans la zone phréatique est la résultante de : 1) la composition chimique du fluide issue de la zone vadose sus-jacente ; 2) la composition chimique $\chi_{marin}$ de l'eau marine issue du biseau sous-jacent (schématisé par la flèche WM dans la Figure 2) ; 3) la composition chimique du fluide $\chi_{moy}$ dans la colonne amont, ou bien une composition chimique initiale prédéfinie dans le cas de la colonne de mailles la plus en amont (par exemple, on peut choisir une composition chimique du fluide initiale correspondant à la composition chimique de la nappe phréatique à l'actuel). Ainsi, dans chaque maille de la zone phréatique, le déséquilibre chimique entre la composition chimique du fluide et la composition minéralogique initiale (correspondant à la composition minéralogique déterminée à l'issue de l'étape de simulation stratigraphique pour le pas de temps considéré) modifie au moins la composition minéralogique $M_i$, la porosité résiduelle $\phi_{ri}$ au sein de la maille $i$ et la composition chimique $\chi_i$ du fluide. Selon une mise en œuvre de l'invention, ces modifications sont moyennées par colonne, et une nouvelle composition chimique du fluide est transférée latéralement à la colonne de mailles avale adjacente. Ainsi, ce premier mode principal de réalisation de l'invention vise à représenter les effets d'une diagenèse météorique, incluant les processus de dissolution, recristallisation et cimentation qui prennent place lorsqu'une couche de sédiments déposée en milieu marin est émergée et soumise à un flux de fluide météorique.

Selon un second mode principal de réalisation de l'invention dans lequel le bassin sédimentaire comprend au moins un dépôt sédimentaire de type évaporite (résultant d'un dépôt en milieu hyper salin), le modèle diagénétique peut rendre compte des effets induits par des flux hydrologiques de directions variables : une percolation verticale (liée aux précipitations) et un flux latéral lié au reflux des saumures. Le modèle diagénétique peut être mis en œuvre de la façon suivante pour ce second mode principal de réalisation de l'invention :

- Pour toute maille dont la composition minéralogique est de type évaporitique, on simule un processus de percolation verticale du fluide sursalé au sein des mailles directement sous-jacentes. Si une maille sous-jacente est de minéralogie calcaire et si le rapport Mg/Ca du fluide percolant est supérieur ou égale à une valeur prédéfinie (très classiquement fixée à 6), la composition minéralogique initiale est modifiée en une minéralogie de type dolomitique. La composition chimique du fluide en sortie d'une maille est également modifiée par ces interactions fluides-roches. La composition chimique du fluide entrant dans une maille est donc fonction de la composition du fluide dans la maille sus-jacente. Cette modélisation des modifications diagénétiques (nommément dolomitisation) est arrêtée quand le rapport Mg/Ca du fluide percolant est inférieur à une valeur prédéfinie, très préférentiellement valant 6.

- En parallèle, on simule un flux latéral des saumures, pour représenter le phénomène de « reflux ». Selon une mise en œuvre de l'invention, la composition chimique du fluide associé à ce reflux est la résultante moyennée de la composition chimique du fluide présent dans la colonne de mailles dans laquelle s'est produit la modification diagénétique, tel que décrit ci-dessus. Ce reflux est alors transféré latéralement à la colonne de mailles avale adjacente.

**4- Exploitation des hydrocarbures du bassin sédimentaire**

A l'issue de l'application des étapes 1) à 3) précédentes, préférentiellement appliquées pour chaque pas de temps de la simulation stratigraphique, on dispose d'une prédiction précise au moins de la distribution de la minéralogie et de la porosité, à partir desquelles on peut par exemple déterminer d'autres propriétés pétrophysiques et/ou mécaniques au sein du bassin étudié. De telles informations, qui plus est fiables, contribuent à améliorer la connaissance du bassin étudié, et permettent ainsi de déterminer notamment si un réservoir de bonne qualité est présent au sein du bassin, quels sont les chemins de migration des hydrocarbures possibles, ou encore pour définir un schéma d'exploitation du réservoir identifié.

En effet, ces propriétés peuvent être notamment utiles en entrée d'une simulation de bassin (telle que par exemple réalisée au moyen du logiciel TemisFlow ® (IFP Energies nouvelles, France) qui permet notamment de quantifier le potentiel pétrolier d'un bassin, d'une simulation d'écoulement (telle que par exemple réalisée au moyen du logiciel PumaFlow ® (IFP Energies nouvelles, France)) qui permet de définir au moins un schéma d'exploitation des hydrocarbures présents dans le bassin.

Par exemple, la détermination d'un schéma d'exploitation comprend la définition d'un nombre, d'une géométrie et d'une implantation (position et espacement) de puits injecteurs et producteurs, la détermination d'un type de récupération assistée (par injection d'eau, de tensioactifs, etc.), etc. Un schéma d'exploitation d'un réservoir d'hydrocarbures doit par exemple permettre un fort taux de récupération des hydrocarbures piégés dans le réservoir géologique identifié, sur une longue durée d'exploitation, nécessitant un nombre de puits et/ou d'infrastructures limité.

De manière classique, la détermination d'un schéma d'exploitation des hydrocarbures est réalisée à l'aide d'une simulation d'écoulement, exploitant notamment des propriétés pétrophysiques telles que la perméabilité et la porosité. Ainsi, les étapes 1) à 3) telles que décrites précédemment, préférentiellement répétées pour chaque pas de temps de la simulation stratigraphique, permettant d'améliorer la connaissance de ces propriétés, le résultat de la simulation d'écoulement est plus précis, ce qui permet d'améliorer l'étape de détermination d'un schéma d'exploitation des hydrocarbures.

Puis, une fois un schéma d'exploitation défini, les hydrocarbures piégés dans le réservoir sont exploités en fonction de ce schéma d'exploitation, notamment en forant les puits injecteurs et producteurs du schéma d'exploitation ainsi déterminé, et en installant les infrastructures de production nécessaires au développement du gisement.

Ainsi, la présente invention permet, via un couplage entre une simulation stratigraphique, un modèle hydrologique et un modèle diagénétique, la prise en compte des effets des flux hydrologiques au sein d'un bassin sédimentaire. Notamment, la présente invention permet une modélisation de l'évolution de la composition chimique des fluides circulant au sein du bassin et de fait, permet de modéliser de façon plus réaliste les modifications diagénétiques liées aux circulations de fluide dans un bassin. De cette manière, la présente invention contribue à une meilleure connaissance du bassin sédimentaire étudié, et permet ainsi de définir des conditions permettant une exploitation optimale de ce bassin.

**Produit programme d'ordinateur**

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

**Revendications**

1.   Procédé pour exploiter des hydrocarbures au sein d'un bassin sédimentaire, ledit bassin résultant d'une succession de dépôts sédimentaires au cours du temps, au moins une partie desdits dépôts sédimentaires ayant été soumis à des circulations de fluides, ledit procédé étant mis en œuvre à partir de mesures de propriétés relatives à la stratigraphie et à l'hydrologie dudit bassin et au moyen d'un simulateur stratigraphique exécuté sur ordinateur, ledit simulateur stratigraphique permettant la détermination d'une représentation maillée représentative de la stratigraphie dudit bassin pour une succession de pas de temps, **caractérisé en ce que**, pour chacun desdits pas de temps :

   A. au moyen dudit simulateur et de paramètres dudit simulateur pour ledit pas de temps construits à partir desdites mesures, on détermine ladite représentation maillée représentative de la stratigraphie dudit bassin pour ledit pas de temps, chacune des mailles de ladite représentation maillée comprenant au moins une composition minéralogique et une porosité ;
   B. au moyen d'un modèle hydrologique et de paramètres dudit modèle hydrologique construits à partir desdites mesures et de ladite représentation maillée déterminée au moyen dudit simulateur pour ledit pas de temps, on délimite au moins une zone hydrologique au sein dudit bassin pour ledit pas de temps et on détermine en chacune des mailles de la représentation maillée situées dans ladite zone au moins une composition chimique desdits fluides et une direction de circulation desdits fluides dans ladite zone ;
   C. on met à jour au moins ladite composition chimique desdits fluides, ladite composition minéralogique et ladite porosité en chacune des mailles de ladite représentation maillée au moyen d'un modèle diagénétique comprenant :

      i. un bilan des flux hydrologiques, établi au moyen au moins desdites directions de circulation desdits fluides, à partir duquel on détermine un ordre de parcours desdites mailles par lesdits fluides ;
      ii. un modèle cinétique réactionnel modélisant les interactions entre ladite composition chimique desdits fluides et ladite composition minéralogique dans ladite maille ;

   ladite composition chimique desdits fluides en entrée dudit modèle diagénétique correspondant à ladite composition chimique desdits fluides pour ledit pas de temps précédent dans ladite succession desdits pas de temps,

   et **en ce que**, à partir au moins de ladite composition minéralogique et de ladite porosité mises à jour pour chacun desdits pas de temps, on quantifie le potentiel pétrolier dudit bassin sédimentaire et/ou on définit un schéma d'exploitation dudit bassin, et on exploite ledit bassin sédimentaire en fonction de ladite quantification et/ou dudit schéma.

2.   Procédé selon la revendication 1 dans lequel, à partir de ladite composition minéralogique et de ladite porosité mises à jour, et au moyen d'une méthode d'homogénéisation, on détermine en sus une perméabilité et/ou un coefficient de Poisson et/ou un module d'Young en chacune des mailles de ladite représentation maillée pour ledit pas de temps.

3.   Procédé selon l'une des revendications précédentes, dans lequel ledit modèle hydrologique implémente une équation de Navier-Stokes modifiée en ce que la vitesse de transport desdits fluides est conditionnée par des gradients de pression.

4.   Procédé selon l'une des revendications précédentes, dans lequel on délimite une pluralité de zones hydrologiques au moyen dudit modèle hydrologique et dans lequel on détermine en sus une direction de circulation desdits fluides entre lesdites zones hydrologiques.

5.   Procédé selon l'une des revendications précédentes, dans lequel au moins une zone hydrologique de type zone vadose a été délimitée au moyen dudit modèle hydrologique, et dans lequel on attribue une direction de circulation desdits fluides verticale dans lesdites mailles de ladite zone vadose.

6. Procédé selon la revendication 5, dans lequel ledit ordre de parcours dans ladite zone vadose est organisé d'une maille à une maille sous-jacente à l'intérieur d'une colonne de mailles situées dans ladite zone vadose, et de manière indépendante d'une colonne de mailles à une autre colonne de mailles situées dans ladite zone vadose.

7. Procédé selon l'une des revendications précédentes, dans lequel au moins une zone hydrologique de type zone phréatique a été délimitée au moyen dudit modèle hydrologique, et dans lequel on attribue une direction de circulation desdits fluides latérale dans lesdites mailles de ladite zone phréatique.

8. Procédé selon la revendication 7, dans lequel ledit ordre de parcours dans ladite zone phréatique est organisé colonne de mailles par colonnes de mailles, et dans lequel ladite composition desdits fluides entrant dans une desdites colonnes de ladite zone phréatique est fonction de ladite composition desdits fluides moyenne dans ladite colonne de mailles située en amont.

9. Procédé selon l'une des revendications précédentes, dans lequel ledit bassin comprend au moins un dépôt sédimentaire de type évaporite sus-jacent à un dépôt sédimentaire de type carbonaté, et dans lequel ledit modèle cinétique réactionnel tient compte du rapport Magnésium sur Calcium de ladite composition chimique desdits fluides en chacune desdites mailles.

10. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications précédentes, lorsque ledit programme est exécuté sur un ordinateur.

**Patentansprüche**

1. Verfahren zur Erschließung der Kohlenwasserstoffe in einem Sedimentbecken, wobei das Becken aus einer Abfolge von Sedimentablagerungen im Laufe der Zeit resultiert, wobei mindestens ein Teil der Sedimentablagerungen Fluidströmungen unterworfen gewesen ist, wobei das Verfahren ausgehend von Messungen von Eigenschaften bezüglich der Stratigraphie und der Hydrologie des Beckens und mittels eines auf einem Computer ausgeführten stratigraphischen Simulators umgesetzt wird, wobei der stratigraphische Simulator die Bestimmung einer Gitterdarstellung ermöglicht, die für die Stratigraphie des Beckens für eine Abfolge von Zeitschritten repräsentativ ist, **dadurch gekennzeichnet, dass**, für jeden der Zeitschritte:

A. mittels des Simulators und von Parametern des Simulators für den Zeitschritt, die ausgehend von den Messungen erstellt werden, die Gitterdarstellung bestimmt wird, die für die Stratigraphie des Beckens für den Zeitschritt repräsentativ ist, wobei jede der Gitterzellen der Gitterdarstellung mindestens eine mineralogische Zusammensetzung und eine Porosität umfasst;
B. mittels eines hydrologischen Modells und von Parametern des hydrologischen Modells, die ausgehend von den Messungen und von der mittels des Simulators für den Zeitschritt bestimmten Gitterdarstellung erstellt werden, mindestens eine hydrologische Zone in dem Becken für den Zeitschritt abgegrenzt wird und in jeder der Gitterzellen der Gitterdarstellung, die in der Zone gelegen sind, mindestens eine chemische Zusammensetzung der Fluide und eine Strömungsrichtung der Fluide in der Zone bestimmt werden;
C. mindestens die chemische Zusammensetzung der Fluide, die mineralogische Zusammensetzung und die Porosität in jeder der Gitterzellen der Gitterdarstellung mittels eines diagenetischen Modells aktualisiert werden, umfassend:

i. eine Bilanz der hydrologischen Ströme, die mittels mindestens der Strömungsrichtungen der Fluide erstellt wird, von der ausgehend eine Reihenfolge des Durchlaufens der Gitterzellen durch die Fluide bestimmt wird;
ii. ein reaktionskinetisches Modell, das die Interaktionen zwischen der chemischen Zusammensetzung der Fluide und der mineralogischen Zusammensetzung in der Gitterzelle modelliert;

wobei die chemische Zusammensetzung der Fluide im Eingang des diagenetischen Modells der chemischen Zusammensetzung der Fluide für den vorausgegangenen Zeitschritt in der Abfolge der Zeitschritte entspricht,

und dadurch, dass ausgehend mindestens von der mineralogischen Zusammensetzung und der Porosität, die für jeden der Zeitschritte aktualisiert wurden, das Erdölpotenzial des Sedimentbeckens quantifiziert wird und/oder ein Erschließungsschema des Beckens definiert wird und das Sedimentbecken in Abhängigkeit von der Quantifizierung und/oder von dem Schema erschlossen wird.

2. Verfahren nach Anspruch 1, bei dem, ausgehend von der aktualisierten mineralogischen Zusammensetzung und der aktualisierten Porosität und mittels einer Homogenisierungsmethode zusätzlich eine Permeabilität und/oder eine Poissonzahl und/oder ein Elastizitätsmodul in jeder der Gitterzellen der Gitterdarstellung für den Zeitschritt bestimmt wird bzw. werden.

3. Verfahren nach einem der vorhergehenden Ansprüche, bei dem das hydrologische Modell eine Navier-Stokes-Gleichung implementiert, die dahingehend modifiziert ist, dass die Transportgeschwindigkeit der Fluide durch Druckgradienten bedingt wird.

4. Verfahren nach einem der vorhergehenden Ansprüche, bei dem eine Mehrzahl von hydrologischen Zonen mittels des hydrologischen Modells abgegrenzt wird und bei dem zusätzlich eine Strömungsrichtung der Fluide zwischen den hydrologischen Zonen bestimmt wird.

5. Verfahren nach einem der vorhergehenden Ansprüche, bei dem mindestens eine hydrologische Zone von der Art einer vadosen Zone mittels des hydrologischen Modells abgegrenzt worden ist und bei dem eine vertikale Strömungsrichtung der Fluide in den Gitterzellen der vadosen Zone zugewiesen wird.

6. Verfahren nach Anspruch 5, bei dem die Reihenfolge des Durchlaufens in der vadosen Zone von einer Gitterzelle zu einer darunter liegenden Gitterzelle innerhalb einer Spalte von Gitterzellen, die in der vadosen Zone gelegen sind, und unabhängig von einer Spalte von Gitterzellen zu einer anderen Spalte von Gitterzellen, die in der vadosen Zone gelegen sind, organisiert wird.

7. Verfahren nach einem der vorhergehenden Ansprüche, bei dem mindestens eine hydrologische Zone von der Art einer phreatischen Zone mittels des hydrologischen Modells abgegrenzt worden ist und bei dem eine seitliche Strömungsrichtung der Fluide in den Gitterzellen der phreatischen Zone zugewiesen wird.

8. Verfahren nach Anspruch 7, bei dem die Reihenfolge des Durchlaufens in der phreatischen Zone Gitterzellenspalte für Gitterzellenspalte organisiert ist und bei dem die Zusammensetzung der in eine der Spalten der phreatischen Zone eintretenden Fluide von der durchschnittlichen Zusammensetzung der Fluide in der stromauf gelegenen Gitterzellenspalte abhängig ist.

9. Verfahren nach einem der vorhergehenden Ansprüche, bei dem das Becken mindestens eine evaporitische Sedimentablagerung umfasst, die über einer karbonatischen Sedimentablagerung liegt, und bei dem das reaktionskinetische Modell das Magnesium-Calcium-Verhältnis der chemischen Zusammensetzung der Fluide in jeder der Gitterzellen berücksichtigt.

10. Computerprogrammprodukt, das von einem Kommunikationsnetzwerk herunterladbar ist und/oder auf einem computerlesbaren Datenträger gespeichert ist und/oder von einem Prozessor ausführbar ist, umfassend Programmcodeanweisungen, die bei der Ausführung des Programms auf einem Computer das Verfahren nach einem der vorhergehenden Ansprüche umsetzen.

**Claims**

1. Method for exploiting for hydrocarbons within a sedimentary basin, said basin resulting from a succession of sedimentary deposits over time, at least some of said sedimentary deposits having been subjected to flowing fluids, said method being implemented on the basis of measurements of properties relating to the stratigraphy and to the hydrology of said basin and by means of a stratigraphic simulator run on a computer, said stratigraphic simulator allowing the determination of a mesh representation representative of the stratigraphy of said basin for a succession of time intervals, **characterized in that**, for each of said time intervals:

A. by means of said simulator and parameters of said simulator for said time interval constructed on the basis of said measurements, said mesh representation representative of the stratigraphy of said basin for said time interval is determined, each of the cells of said mesh representation comprising at least one mineralogical composition and a porosity;
B. by means of a hydrological model and parameters of said hydrological model constructed on the basis of said measurements and of said mesh representation determined by means of said simulator for said time interval, at least one hydrological zone is delimited within said basin for said time interval and at least one chemical composition of said fluids and a direction of flow of said fluids in said zone are determined in each of the cells of the mesh representation which are located in said zone;
C. at least said chemical composition of said fluids, said mineralogical composition and said porosity in each of the cells of said mesh representation are updated by means of a diagenetic model comprising:

i. a balance of the hydrological flows, established by means of at least said directions of flow of said fluids, on the basis of which an order of traversal of said cells by said fluids is determined;

ii. a reaction kinetic model modelling the interactions between said chemical composition of said fluids and said mineralogical composition in said cell;

said chemical composition of said fluids as input to said diagenetic model corresponding to said chemical composition of said fluids for said preceding time interval in said succession of said time intervals,

and **in that**, on the basis at least of said mineralogical composition and of said porosity updated for each of said time intervals, the petroleum potential of said sedimentary basin is quantified and/or an exploitation plan for said basin is defined, and said sedimentary basin is exploited according to said quantification and/or said plan.

2. Method according to Claim 1, in which, on the basis of said updated mineralogical composition and of said updated porosity, and by means of a homogenization method, a permeability and/or a Poisson's ratio and/or a Young's modulus are additionally determined in each of the cells of said mesh representation for said time interval.

3. Method according to one of the preceding claims, in which said hydrological model implements a Navier-Stokes equation which is modified in that the speed of transport of said fluids is determined by pressure gradients.

4. Method according to one of the preceding claims, in which a plurality of hydrological zones are delimited by means of said hydrological model and in which a direction of flow of said fluids between said hydrological zones is additionally determined.

5. Method according to one of the preceding claims, in which at least one hydrological zone of vadose zone type has been delimited by means of said hydrological model, and in which a vertical direction of flow of said fluids is assigned in said cells of said vadose zone.

6. Method according to Claim 5, in which said order of traversal in said vadose zone is organized from one cell to an underlying cell within a column of cells located in said vadose zone, independently from one column of cells to another column of cells located in said vadose zone.

7. Method according to one of the preceding claims, in which at least one hydrological zone of phreatic zone type has been delimited by means of said hydrological model, and in which a lateral direction of flow of said fluids is assigned in said cells of said phreatic zone.

8. Method according to Claim 7, in which said order of traversal in said phreatic zone is organized column of cells by column of cells, and in which said composition of said fluids entering one of said columns of said phreatic zone is dependent on the average composition of said fluids in said column of cells located upstream.

9. Method according to one of the preceding claims, in which said basin comprises at least one sedimentary deposit of evaporite type overlying a sedimentary deposit of carbonate type, and in which said reaction kinetic model takes into account the magnesium-to-calcium ratio of said chemical composition of said fluids in each of said cells.

10. Computer program product that can be downloaded from a communication network and/or is stored on a medium that can be read by computer and/or can be executed by a processor, comprising program code instructions for implementing the method according to one of the preceding claims, when said program is run on a computer.

Figure 1A

Figure 1B

Figure 1C

Figure 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3104199 A
- US 6423664 B

**Littérature non-brevet citée dans la description**

- Concepts and applications of a 3D multiple lithology, diffusive model in stratigraphic modeling. **GRANJEON D. ; JOSEPH P.** Numerical Experiments in Stratigraphy: Recent Advances in Stratigraphic and Sedimentologic Computer Simulations. SEPM Special Publications, 1999, vol. 62, 197-210
- **PACKHURST D. L.** User's guide to PHREEQC - a computer program for speciation reaction-path, advection-transport and inverse geochemical calculations. *Unisted States Geological Survey Water Resources Investigation Report,* 1995, 95-4227
- **VACHER H.L.** Dupuit-Ghyben-Herzberg analysis of strip-islands lenses: Geological Society of America. *Bulletin,* 1988, vol. 100, 580-591
- **VACHER H. L. ; BENGTSSON T. O. ; PLUMMER L. N.** Hydrology of meteoric diagenesis: residence time of meteoric ground water in island fresh-water lenses with application to aragonite-calcite stabilization rate in Bermuda. *Geological Society of America Bulletin,* 1990, vol. 102, 223-232
- Structure and function of a coupled two-dimensional diagenetic and sedimentological model of carbonate platform evolution. **WHITAKER F. F. ; SMART P. ; HAGUE Y. ; WALTHAM D. ; BOSENCE D.** Numerical Experiments in Stratigraphy: Recent Advances in Stratigraphie and Sedimentologic Computer Simulations. SEPM Spécial Publications, 1999, vol. 62, 337-355

- **WHITAKER F. F. ; SMART P. L.** Geochemistry of meteoric diagenesis in carbonate islands of the northern Bahamas: 2. Geochemical modelling and budgeting of diagenesis. *Hydrological Processes,* 2007, vol. 21 (7), 967-982
- **WHITAKER F. F. ; FELCE G. P. ; BENSON G. S. ; AMOUR F. ; MUTTI M. ; SMART P.L.** Simulating flow through forward sediment model stratigraphies: insights into climatic control of reservoir quality in isolated carbonate platforms. *Petroleum Geoscience,* 2014, vol. 20, 27-40
- **ALBERTO CONSONNI et al.** Application of numerical modelling to a case of compaction-driven dolomitization: a Jurassic palaeohigh in the Po Plain, Italy. *SEDIMENTOLOGY,* 2009, vol. 57 (1), ISSN 0037-0746, 209-231
- **YITIAN XIAO et al.** Reactive transport modeling of carbonate and siliciclastic diagenesis and reservoir quality prédiction. *2006 ABU DHABI INTERNATIONAL PETROLEUM EXHIBITION AND CONFERENCE,* 05 Novembre 2006